Europäisches Patentamt

European Patent Office

Office européen des brevets

(19)

(11) Publication number: **0 064 406**
**A1**

(12) # EUROPEAN PATENT APPLICATION

(21) Application number: 82302264.5

(22) Date of filing: 04.05.82

(51) Int. Cl.³: **G 11 B 5/09**
**H 04 L 25/49**

(30) Priority: 05.05.81 US 260248

(43) Date of publication of application:
10.11.82 Bulletin 82/45

(84) Designated Contracting States:
DE FR GB IT

(71) Applicant: SPERRY CORPORATION
1290, Avenue of the Americas
New York, N.Y. 10019(US)

(72) Inventor: Jacoby, George Victor
1315 Middleton Court
Los Altos California 94022(US)

(72) Inventor: Cohn, Martin
167 Jason Street
Arlington Massachusetts 02174(US)

(74) Representative: Michaels, Peter Albert
SPERRY UNIVAC International Patent Department Mail
Station N3 W3 SPERRY UNIVAC CENTRE
Brentfields London NW10 8LS(GB)

(54) Encoding binary data.

(57) To improve data capacity in transmission and storage systems, binary data words of n elements are encoded as ternary words of m elements. Ternary 0 is represented by the absence of a signal change, a ternary 1 is represented by a single transition and a ternary 2 is represented by a pulse or pair of closely spaced transitions. Additionally, ternary code symbols can be merged so as to prevent the spacing between adjacent symbols from becoming so small as to create undesirable crowding. Also, extra symbols can be inserted, and other shifted to prevent the spacing between adjacent symbols from becoming so great as to adversely affect recovery of the encoded data.

| SERIAL NUMBER | DATA WORDS | | | | TERNARY CODE WORDS | | | | | |
| | PRESENT | | FOLLOWING | | PRESENT | | | FOLLOWING | | |
| | DI | D2 | D'I | D'2 | PI | P2 | P3 | P'I | P'2 | P3 |
| 0 | 0 | 0 | 0 | 0 | 0 | 1 | 0 | 0 | 1 | 0 |
| 1 | 0 | 0 | 0 | 1 | 0 | 1 | 0 | 0 | 2 | 0 |
| 2T | 0 | 0 | 1 | 0 | 0 | 1 | 0 | 1 | 0 | 0 |
| 2 | 0 | 0 | 1 | 0 | 0 | 0 | 1 | 0 | 0 | 0 |
| 3T | 0 | 0 | 1 | 1 | 0 | 1 | 0 | 2 | 0 | 0 |
| 3 | 0 | 0 | 1 | 1 | 0 | 0 | 0 | 2 | 0 | 0 |
| 4 | 0 | 1 | 0 | 0 | 0 | 2 | 0 | 0 | 1 | 0 |
| 5 | 0 | 1 | 0 | 1 | 0 | 2 | 0 | 0 | 2 | 0 |
| 6T | 0 | 1 | 1 | 0 | 0 | 2 | 0 | 1 | 0 | 0 |
| 6 | 0 | 1 | 1 | 0 | 0 | 0 | 0 | 1 | 0 | 0 |
| 7T | 0 | 1 | 1 | 1 | 0 | 2 | 0 | 2 | 0 | 0 |
| 7 | 0 | 1 | 1 | 1 | 0 | 0 | 2 | 0 | 0 | 0 |
| 8 | 1 | 0 | 0 | 0 | 1 | 0 | 0 | 0 | 1 | 0 |
| 9 | 1 | 0 | 0 | 1 | 1 | 0 | 0 | 0 | 2 | 0 |
| 10 | 1 | 0 | 1 | 0 | 1 | 0 | 0 | 1 | 0 | 0 |
| 11 | 1 | 0 | 1 | 1 | 1 | 0 | 0 | 2 | 0 | 0 |
| 12 | 1 | 1 | 0 | 0 | 2 | 0 | 0 | 0 | 1 | 0 |
| 13 | 1 | 1 | 0 | 1 | 2 | 0 | 0 | 0 | 2 | 0 |
| 14 | 1 | 1 | 1 | 0 | 2 | 0 | 0 | 1 | 0 | 0 |
| 15 | 1 | 1 | 1 | 1 | 2 | 0 | 0 | 2 | 0 | 0 |

T MEANS TENTATIVE, BEFORE MERGE/SKIP

*Fig-2*

EP 0 064 406 A1

## Encoding Binary Data

This invention relates to the encoding of binary digital data. The method of encoding, and the apparatus for performing the method of encoding, has applicability to digital data communications systems and magnetic data storage systems.

The encoding of binary data for transmission, or for recording on a magnetic medium, has long been recognised as desirable, the result being substantial increases in the data capacity of the system concerned. In the case of a magnetic storage system, for example, this increase in data capacity can normally be achieved without requiring any substantial alteration to the physical characteristics of the read/write head and the recording medium, or either of them.

A summary of some of the known techniques for encoding data is set out in U.S. patent No. 4,323,931 (inventor: George V. Jacoby; assignee: Sperry Corporation). Further summaries of various prior art binary encoding and recording techniques can be found in an article entitled "An Optimization of Modulation Codes in Digital Recording" by T. Horiguchi and K. Morita, I.E.E.E. Transactions on Magnetics, Vol. Mag. 12, No. 6 of 6 November 1976; and in an article entitled "A New Look-Ahead Code for Increased Data Density", I.E.E.E. Transactions on Magnetics, Vol. Mag. 13, No. 5 of September 1977. These references summarise the progressive development of codes from the so-called NRZ code up to and including the 3PM code, and the resultant substantial increase in the storage capacity of magnetic data storage equipment, such as disk packs and the like.

The present invention sets out to provide a method of coding which constitutes a further improvement on the aforementioned coding techniques. A series of binary data bits is encoded as a series of ternary code symbols identified as ternary 0, ternary 1, and ternary 2. Binary data bits are grouped to form a series of bit groups on n characters, whereby each group can have any one of $2^n$ values, n being a positive integer greater than unity. The n binary data bits are encoded into m code signals, where m is a positive integer greater than n, thereby to establish a pattern of code signals uniquely representative of the value of a binary data bit group. The pattern of code signals is serialised to produce a serial stream of code signals at pre-selected time intervals and, finally, ternary code symbols, or states, are generated to represent each code signal, whereby a ternary 1 code symbol is represented by a first kind of signal change, a ternary 2 code symbol is represented by a second kind of signal change, and a ternary 0 code signal is represented by other than a signal change of the first kind or a signal change of the second kind.

Application to the ternary encoding of the present invention of the merging techniques described in the above-mentioned U.S. patent 4,323,931, suitably adapted to ternary encoding, will result in an increased minimum separation between ternary code symbols and so further increases the amount of data representable by a single signal change. An example of how to adapt the merging technique to ternary encoding is described below.

In addition, substitution techniques described in the aforementioned U.S. patent, again suitably adapted to ternary encoding, may be employed to limit the maximum distance between adjacent signal changes.

Given a system in which the information carrier, e.g. the magnetic surface of a disk, is capable of assuming two states of opposite polarity, the first ternary code symbol may conveniently take the form of a transition from one polarity to the opposite polarity, the second ternary code symbol the form of a pair of closely spaced transitions, also referred to as a pulse, in which the first transition goes from one polarity to the other and the second returns to the original polarity, and the third ternary code symbol by no transition at all. Such a system is said to provide two level ternary encoding.

Another aspect of the present invention is the provision of apparatus to encode binary data for transmission or recording. Apparatus for encoding a series of binary data bits as a series of ternary code symbols identified as ternary 0, ternary 1 or ternary 2, comprises data storage means in which an input stream of binary data is divided into successive data bit groups of n data bits, each having any one of $2^n$ values, where n is a positive integer greater than 1. Encoding means having n inputs which are coupled to the data storage means, and m outputs, where m is a positve integer greater than n, establish at the outputs a pattern of parallel ternary code signals, each of which is uniquely representative of a binary data bit group applied to the inputs. Serialising means are coupled to the encoding means to convert the parallel ternary code signal pattern into a serial stream of ternary code signals occupying at least nominally, pre-selected code signal positions. Ternary code symbol generating means are coupled to the serialising means for forming an output stream of ternary states. Conveniently, a first type of signal change is generated between two signal levels at positions corresponding to a ternary 1, a second type of signal change between said signal levels at positions corresponding to a ternary 2, and neither a first type nor a second type of signal change at positions corresponding to a ternary 0 which will generally be represented by the absence of a signal change in those positions.

The invention further provides apparatus for decoding the previously encoded ternary code symbols.

In the case of a magnetic data storage system, it is an object of the invention to increase the data capacity without altering the read/write head, the magnetic medium, or the interface between the head and the medium. This object is achieved by employing a ternary code in which one ternary state is manifested on the medium by lack of a transition, another ternary state is manifested by a first magnetic pattern, and a third magnetic state is manifested by a second magnetic pattern. The reliability of data recording and recovery is assured by using saturation recording, and by representing the ternary code symbols, or states, by write signals and magnetic signals which are readily distinguishable from one another.

Conveniently, the first magnetic pattern is a single transition from one polarity of saturation to the opposite polarity, and the second magnetic pattern is a pair of closely-spaced transitions, the first going from one polarity to the other polarity, and the second returning to the original polarity. The magnetic patterns may be readily distinguished by establishing a basic spacing such that two transitions separated by not more than the basic spacing so interact with one another on detection by a read head as to reduce the amplitude of the signal produced in the read head. Thus by writing the first symbol onto the medium as a pair of sequential transitions of opposite polarity, which are separated from one another by not more than the spacing and by writing the second symbol onto the medium as a single transition from one to the other saturation polarity, and ensuring that it is separated from preceding and succeeding transitions by more than the spacing the amplitude of the signal produced in the read head by the second symbol is greater than the amplitude produced by the frist symbol.

A system embodying the invention has a density ratio of data storage that is up to thirty three percent higher than the 3PM system described in the aforementioned U.S. patent 4,323,931. Moreover, the time window employed in reading the data can be up to thirty three percent longer than the window for the 3PM system. Further, propagation of an erroneously recorded code bit on the medium is limited to one code word.

The invention will be described further by way of example and with reference to the accompanying drawings, of which: -

Figure 1 is a simplified table showing a preferred technique for encoding binary data into ternary form.

Figure 2, is a complete encoding table illustrating the preferred encoding technique with merging to assure that the minimum distance between adjacent magnetic patterns is at least a predetermined amount.

Figure 3 is a block diagram of an encoding and recording circuit for carrying out the encoding technique shown in Figures 1 and 2.

Figure 4 is a timing diagram showing encoding, recording and reading of an exemplary sequence of binary data bits.

Figure 5 is a block diagram of a circuit for reading and decoding data recorded in accordance with the invention.

Figure 6 is an encoding table illustrative of an alternate encoding technique in accordance with the principles of the invention.

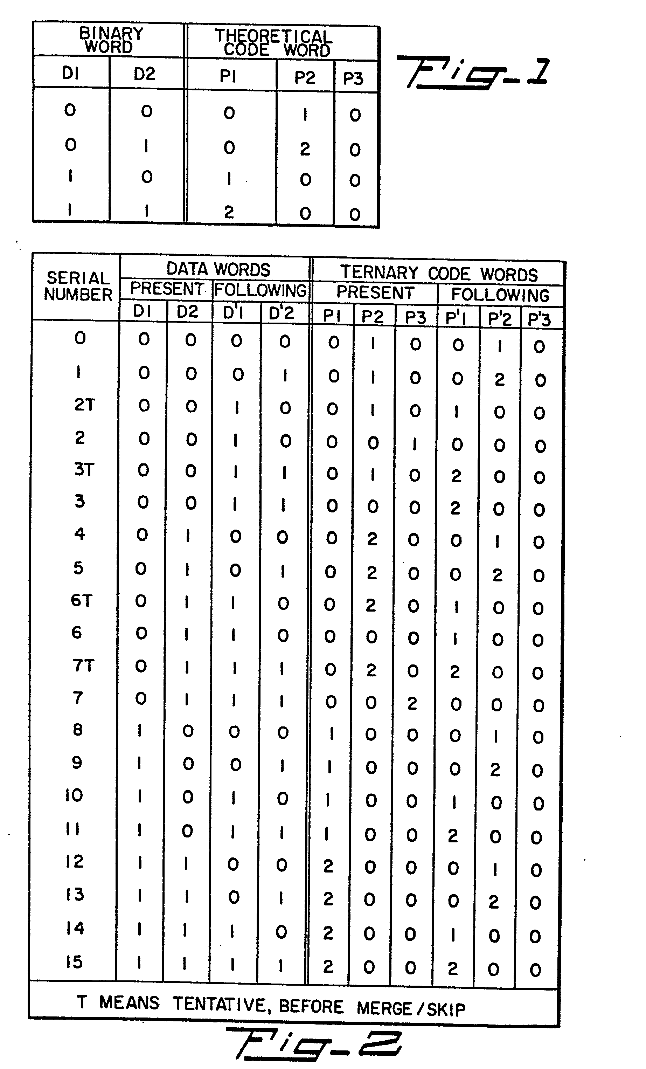

The ternary code exemplified by the table of Figure 1 converts a data word formed by two successive binary data bits D1 and D2 into a code word having three positions or detents. The positions are identified as P1, P2 and P3. The code positions or detents can have one of three values: 0, 1 or 2. A 0 is manifested on the recording medium by absence of a transition, a 1 is manifested by a transition from saturated magnetisation of one polarity to saturated magnetisation of the opposite polarity, and a 2 is manifested by two closely spaced transitions, such two closely spaced transitions sometimes being referred to hereinafter as a pulse.

The code pattern chosen for each of the four data words seen in Figure 1 has two 0's and one other ternary number, either a 1 or a 2. Thus two data bits are represented by one magnetic change. Certain combinations of data words produce adjacent code words that have excessively close magnetic changes. The code words for such combinations are modified by merging or skipping as shown in Figure 2.

In Figure 2, D1 and D2 identify the bits in a present data word, and D'1 and D'2 identify the bits in the next following or succeeding data words. P1, P2 and P3 identify the positions or detents in a present coded word corresponding to the data word composed of bits D1 and D2, and P'1, P'2 and P'3 identify the positions or detents in a following or succeeding code word corresponding to the data word composed of bits D'1 and D'2.

The rows or data word combinations in the table of Figure 2 identified by serial number 0 and serial number 1 illustrate the desired condition that any two successive magnetic changes (those occurring in positions P2 and P'2) are separated from one another by at least two zeros, that is by at least two positions or detents in which no magnetic change occurs. It will be noted further that serial number 0 is distinguished from serial number 1 by the specific code signal recorded in the P'2 position. Study of the table in Figure 2 will show that all code words derived from the coding technique shown in Figure 1 have at least two zeros between adjacent magnetic signals, except the patterns identified by serial numbers 2T, 3T, 6T and 7T. Those four patterns are therefore converted by merging or skipping to form the code patterns (serial numbers 2, 3, 6 and 7) so as to preserve the minimum of two zeros between any two adjacent code signals.

The following merge or skip rules are employed in deriving code words identified as serial numbers 2, 3, 6 and 7 from the patterns identified as serial numbers 2T, 3T, 6T and 7T respectively:

A. If position P2 of the present code word and position P'1 of the following code word have the same ternary code symbols they will be merged into an identical code symbol at position P3 and a ternary 0 code symbol will occur at both of the original positions, P2 and P'1.

B. If position P2 of the present word and position P'1 have different ternary code symbols, the ternary code symbol at position P'1 will remain unchanged and the ternary code symbol originally at position P2 will be skipped and replaced by a ternary 0 code symbol.

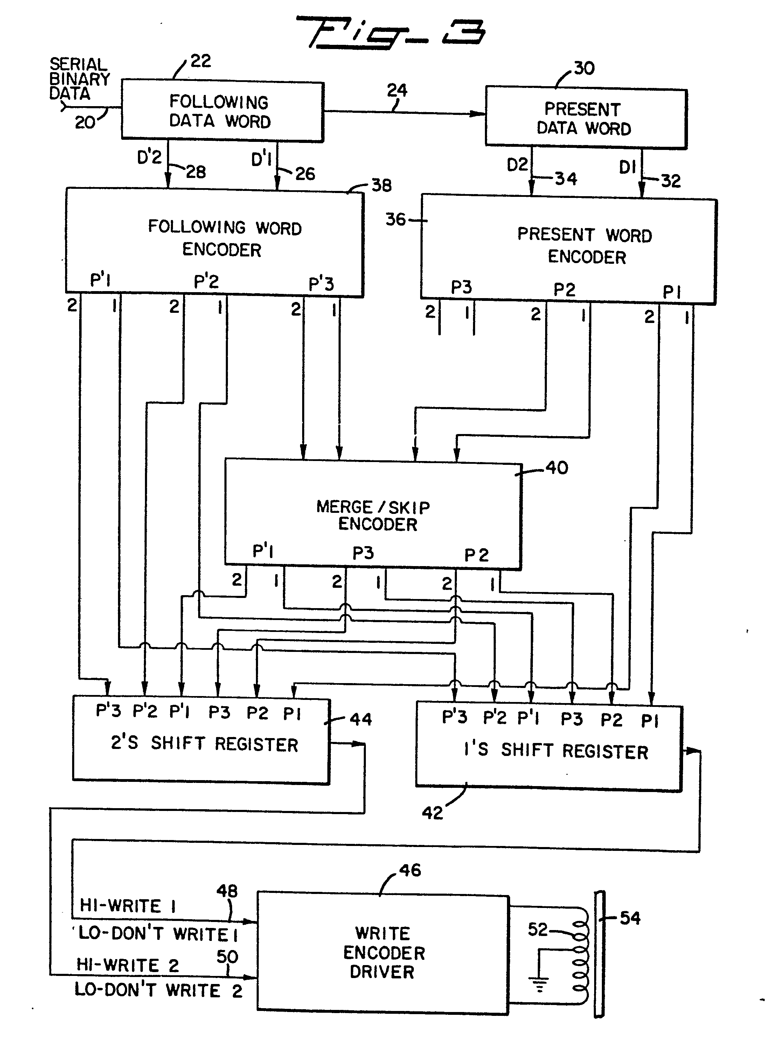

Referring to Figure 3 the binary data identified as D1, D2, D'1 and D'2 in Figure 2 is applied as the input to the circuit at terminal 20. Terminal 20 constitutes the serial input of a shift register 22 which has a serial output 24 and parallel outputs 26 and 28. Serial output 24 is coupled to the serial input of a second shift register 30 which has parallel outputs 32 and 34. Thus, four binary data bits entering the system in serial form are converted to parallel form by shift registers 22 and 30. For encoding the data words in accordance with the scheme tabulated in Figure 2 there is a present word encoder 36 coupled to receive the output of shift register 30 and a following word encoder 38 coupled to receive the output of shift register 22. Encoders 36 and 38 are preferably Read-Only Memories (ROMs) which are constructed to achieve the encoding or mapping tabulated in Figure 2. It will be noted that the outputs of encoders 36 and 38 are each six in number; three represent 1's in the respective positions and three represent 2's in same positions. It is to be understood that these numeric designations are for identification only because the encoders are binary devices and their outputs have one of two values, high or low.

For implementing the previously mentioned merge or skip rules, there is a merge/skip encoder 40 which can also be embodied in a ROM. The inputs to merge/skip encoder 40 are constituted by the P2 and P'1 outputs of encoders 36 and 38. The merge/skip encoder 40 is constructed and arranged to achieve the code patterns shown in Figure 2 at serial numbers 2, 3, 6 and 7.

Merge/skip encoder 40 is a binary device so that the outputs thereof are in either a low state or a high state. Thus, as in the case of present word encoder 36 and following word encoder 38, there are separate outputs representative of the ternary 1 and ternary 2 code symbols for positions P'1, P3 and P2. The outputs of merge/skip encoder 40 are coupled to the inputs of a 1's shift register 42 and a 2's shift register 44. Shift registers 42 and 44 have parallel inputs and serial outputs and act to convert the parallel input signals to serial output signals. The 1's shift register has six inputs coupled to the respective 1 outputs of encoders 36, 38 and 40, and 2's shift register 44 has six inputs coupled to the 2 outputs of such encoders. Thus, the 1's shift register will produce a serial output only in correspondence with a 1 input to any of its input terminals and the 2's shift register 44 will produce a serial output only in response to application of a 2 to one of its inputs. The serial outputs of shift registers 42 and 44 are connected as inputs to a write encoder driver 46, the input from 1's shift register 42 being indicated at 48 and the input from 2's shift register 44 being indicated at 50. Write encoder driver 46 includes a current source for energising a magnetic read/write head 52 and input circuitry to the current source for controlling the same in accordance with the signal conditions at inputs 48 and 50. Read/write head 52 interfaces with a disk 54 or like magnetisable medium so as to afford storage of the ternary code symbols in the form of magnetic change on the surface of the medium.

The timing of the foregoing operations is essentially as follows (and is similar to that explained for the two-thirds rate encoding system described in Japanese patent application 22343/81, based on U.S. patent application Serial No. 122,632 filed February 19 1980 a copy of which is filed as supplementary material to the present patent application). A data bit clock applied to present data word shift register 30 and following data word shift register 22 operates to shift the input serial binary data through the shift registers at the data rate. At the outset of encoding, after the first four data bits (first two binary data words) have been loaded into registers 22 and 30, a momentary word clock pulse applied to 1's shift register 42 and 2's shift register 44 causes the code signals corresponding to the two data words to be loaded into registers 42 and 44. A position clock applied to registers 42 and 44 and occurring at a rate one and a half times that of the data bit clock functions to shift the code signals at positions P1, P2 and P3 out of registers 42 and 44 to the input of write encoder driver 46 during the same interval that the following data word is being shifted into present data word register 30 and the next two binary data bits are shifted into following data word register 22. Then the cycle repeats on occurrence of the next word clock pulse (after every two data bit clocks) applied to 1's and 2's registers 42 and 44 for loading new code signals therein. It will be noted that, except for the first data word, each succeeding data word is encoded twice, first when it is stored in following data word register 22 and again after it is shifted into present data word register 30. If the new code signals corresponding to a data word are different on the occasion of the second encoding from those produced on the occasion of the first encoding, the new code signals loaded into positions P1, P2 and P3 of 1's and 2's shift registers 42 and 44 overwrite the code signals shifted into those positions from positions P'1, P'2 and P'3. Referring to Figure 2 though it will be noted that such overwrite must not occur in the case of the serial numbers 2 and 7 data word combinations because the code signals corresponding to the ternary 1 and ternary 2 code symbols at the P'1 position have already been merged to the P3 position. Such overwrite is precluded simply by sensing when a merge has occurred, that is when a signal appears at the P3 output of merge/skip encoder 40, and in such instances inhibiting the word clock applied to 1's and 2's shift registers 42 and 44, whereby no new code signals are loaded therein until the contents of such registers have been shifted six positions.

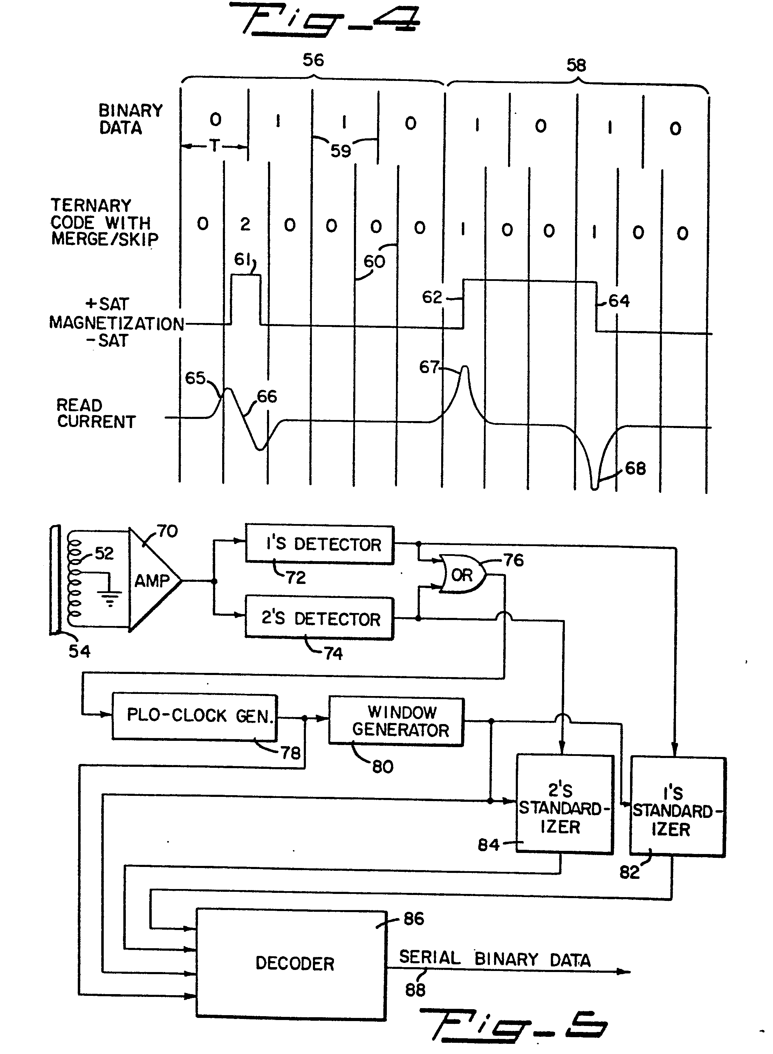

Referring to Figure 4 there are shown at 56 and 58 binary data groups corresponding respectively to the rows in Figure 2 identified as serial numbers 6 and 10. The binary bits regularly occur at an interval T, the boundaries of such intervals being indicated in Figure 4 by vertical lines 59. Below the binary data stream is the ternary code generated by the circuit of Figure 3 and applied to the inputs of write encoder driver 46. Each position or detent in the ternary code is within a cell having a duration of 2/3T and having boundaries indicated by vertical lines 60. Below the ternary code is the magnetisation recorded on the magnetisable medium by magnetic head 52 in response to the ternary code signals applied to write encoder driver 46, there being a ternary 2 in the form of a pulse 61 and two ternary 1's in the form of transitions 62 and 64. Since both a ternary 1 and a ternary 2 are represented by a high level signal applied to write encoder driver 46, the write encoder driver responds to a ternary 1 by supplying current to the magnetic head so as to change the magnetisation on the medium from saturation in one direction to saturation in the opposite direction, and responds to a ternary 2 by first supplying current to the magnetic head in one direction and then in the opposite direction so as to change the magnetisation on the medium from saturation in one direction to saturation in the opposite direction and then back to saturation in the original direction. Logic circuits within write encoder driver 46 ascertain the instantaneous direction of current flow in the magnetic head to assure that appropriate switching thereof occurs. It will be noted that pulse 61 is centered within a cell and that both its positive going and negative going portions are within the cell. It will be further noted that transitions 62 and 64 are in the centres of respective cells. The ternary code is recorded on medium 54 by means of saturation recording with all its attendant benefits.

The lowermost curve in Figure 4 indicates the read voltage induced in the head in response to movement therepast of medium 54 which has been magnetised as shown in Figure 4. The magnetisation on medium 54 represented by pulse 61 produces a doublet signal 65, 66. The magnetisation on the medium represented by transitions 62 and 64 produce respective single pulse signals 67 and 68. The positive and negative amplitudes of doublet signal 65, 66 is less than that of signals 67 and 68 because the closely spaced changes of pulse 61 interact on read out to shift and attenuate the peaks of doublet signal 65, 66 induced in read/write head 52 as is well known in the art.

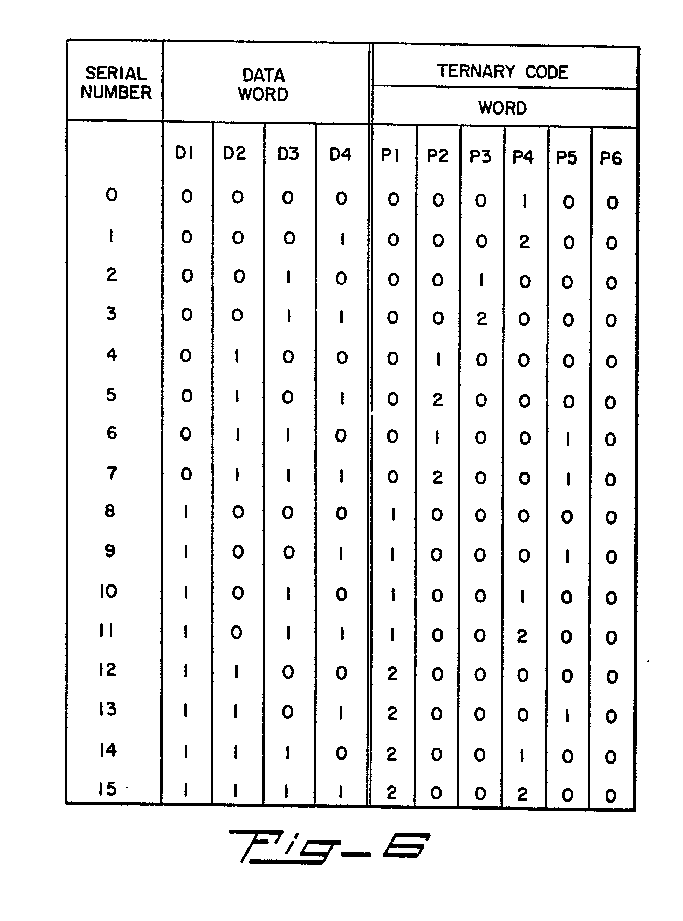

The binary data can be recovered from the read voltage by the circuit shown in block diagram form in Figure 5. As medium 54 moves with respect to head 52 in the read mode, information recorded on the medium in accordance with the invention induces in the head a read voltage consisting of single pulses or doublet pulses as described above in connection with Figure 4. The read head output is coupled to a preamplifier 70, the output of which is coupled to a 1's detector 72 and a 2's detector 74. Detectors 72 and 74 each respond to only one of the ternary signals and can employ one of many discrimination techniques. For example, detectors 72 and 74 can discriminate on the basis of amplitude because, as seen in Figure 4, the read signal induced by a transition has a greater amplitude than the read signal induced by a pulse. Alternatively, the detectors can discriminate on the basis of area under the respective read voltage pulses or can employ a monostable multivibrator which has an output signal of a duration corresponding to that between the positive peak and the negative peak of the read voltage signal induced by a pulse so that occurrence of a pulse during the output of the monostable multivibrator indicates a ternary 2 and the lack of a pulse during such time indicates a ternary 1. In any event, it will be appreciated by those skilled in the art that detection of the position or time occurrence of transitions 62 and 64 is of paramount interest whereas in the case of pulse 61 it is detection of the position or time occurrence of the centre of the pulse that is significant. Hence, read pulses 67 and 68 corresponding to transitions 62 and 64 respectively are detected in conventional manner by differentiating pulses 67 and 68 and sensing the zero crossings of the differentiated pulses as an indication of the position or time occurrence of the transitions. For the read signal doublet 65, 66 corresponding to pulse 61 the locations of the positive and negative going edges (transitions) of pulse 61 are not significant and in fact are not desired to be detected because of the shifting of the peaks of pulses 65 and 66 which inherently occurs due to the close proximity of the edges of pulse 61. The zero crossing of doublet 65, 66 however, has substantially no shift and is in fact precisely indicative of the centre of pulse 61. Pulse 61 is therefore detected simply by sensing the zero crossing of the doublet, thus obviating the need for differentiation. This is very advantageous because, notwithstanding the diminution of the amplitudes of pulses 65 and 66, the elimination of differentiation affords significant enhancement of signal to noise ratio.

The outputs of 1's detector 72 and 2's detector 74 are coupled to an OR gate 76 which has its output coupled to the input of a phase locked oscillator (PLO) 78. The PLO produces in a well known fashion a clock pulse at a frequency corresponding to the rate at which magnetic signals recorded on medium 54 move with respect to head 52. The output of PLO 78 is coupled to a window generator 80 which creates a series of pulses corresponding to the position of vertical lines 60 in Figure 4 so as to define between adjacent pulses time windows that define the time of occurrence of the ternary code positions as read from the medium.

The output of 1's detector 72 is coupled to a 1's standardiser 82 and the output of 2's detector 74 is coupled to a 2's standardiser 84. Also coupled to standardisers 82 and 84 is the output of window generator 80. The outputs of the respective standardisers constitute the code signals representative of the ternary code symbols shown in the right hand columns of Figure 2. Simultaneous low outputs from standardisers 82 and 84 indicate that a 0 is present in the code signal. The code signals from standardisers 82 and 84 are coupled to a decoder circuit 86 to which the outputs of PLO generator 78 and window generator 80 are also coupled. The decoder includes a first shift register for converting the incoming serial data from the standardisers into parallel form, a ROM or like decoding circuit for converting the parallel encoded information to parallel binary information and a second shift register which converts the parallel binary data into serial binary data which is produced at the output 88 of the decoder.

To recapitulate operation of the embodiment of the invention shown in Figures 1-5, it is assumed that a string of binary data is applied to input terminal 20 of the circuit of Figure 3. The incoming serial data word is grouped into a present data word and a following data word by shift registers 22 and 30, all data word combinations being shown in Figure 2. Encoding of the data words into ternary code words is achieved in encoders 36 and 38 for twelve of the sixteen combinations seen in Figure 2. the other four data words, those identified as serial numbers 2, 3, 6, 7 are derived from merge/skip encoder 40 coacting with encoders 36 and 38 so that the ternary code signals are loaded into various positions of shift registers 42 and 44.

Write encoder driver 46 receives the ternary code signals from shift registers 42 and 44 and forms the code signals into bidirectional currents, which when applied to read/write head 52, produce magnetic transition patterns between opposite saturation polarities on medium 54. For a ternary 0 code symbol no write current is supplied to head 52; for a ternary 1 code symbol a signal change exemplified by transitions 62 and 64 is formed; and for a ternary 2 code symbol a signal change exemplified by pulse 61 is formed. Such signal changes or magnetisation patterns are formed in response to currents produced by write encoder driver 46 and applied to head 52. The ternary code symbols are thus stored on medium 54 in readiness for readout. The magnetic change representative of a ternary 1 code symbol is different from the magnetic change representative of a ternary 2 code symbol and therefore the changes are readily distinguished on read out. Moreover, since the magnetic changes employ saturation of the medium at one or the other polarity, accurate recovery of data is facilitated.

The magnetic changes for a ternary 1 code symbol are distinguishable from the magnetic changes for a ternary 2 code symbol because the two transitions in a pulse constituting a ternary 2 are spaced sufficiently close to one another that on read out the signals induced in head 52 by the closely spaced transitions interact with one another to effect a reduction in the amplitude of the voltage induced in the head. Pulse 61 exemplifies the condition that the transitions are spaced from one another by an amount no greater than the interval defining a code cell, that is, the interval between adjacent vertical lines 60. In contrast, transitions 62 and 64 are spaced from one another and from pulse 61 by an amount significantly greater than the duration of a code cell so that each transition representative of a ternary 1 code symbol induces in head 52 a voltage pulse, such as indicated at 67 and 68, that is independent of adjacent transitions of opposite polarity. Thus, the amplitude of pulses 67 and 68 is significantly greater than, and distinguishable from, the amplitude of pulses 65 and 66.

As the magnetic changes on medium 54 interact with head 52, the read voltage signals shown in the lower curve of Figure 4 are produced and such signals are amplified by amplifier 70 (see Figure 5). A signal indicating the occurrence of a ternary 1 code symbol is produced at the output of 1's detector 72 and a signal indicating the occurrence of a ternary 2 code symbol is produced at the output of 2's detector 74. In response to a time window produced by PLO 78 and window generator 80, standardisers 82 and 84 produce signals indicating, respectively, that a ternary 1 or a ternary 2 code symbol has been produced within a given time window. Lack of signals on the outputs of both standardisers during a time window indicates that a ternary 0 code symbol has been produced. Such signals are decoded by decoder 86 so as to recover the originally stored serial binary date.

Inspection of Figure 2 indicates that the minimum number of detents or positions between two adjacent code symbols or magnetic changes is two. This is advantageous to avoid interaction between two adjacent magnetic changes on the medium, which as is well known, makes difficult the accurate recovery of data from the medium. The maximum number of detents without any magnetic change is exemplified by a serial number 2 data word combination followed by a serial number 3 data word combination, there being 6 detents without a magnetic change. Such maximum number of detents without a magnetic change has the result of not synchronising PLO 78 for a corresponding period of time. Present PLO technology is such, however, that a clock signal of accurate frequency can be sustained notwithstanding the relatively long duration without application of a synchronising pulse to the PLO.

The encoding scheme shown in Figure 2 is merely exemplary. An alternate encoding scheme is shown in the table of Figure 6 which is carried out with the circuit of Figure 3 with minor modifications as follows. Present data word register 30 and following data word register 22 each store form bit words. Present word encoder 36 and following word encoder 38 are hexadecimal encoders which respond to the four bit words to produce code signals at positions P1, P2, P3, P4, P5 and P'1, P'2, P'3, P'4, P'5 respectively. Merge/skip encoder 40 performs merging operations only, inclusive of skip operations, for reasons that will be explained presently and responds to code signals at position P5 of the present word encoder and position P'1 of the following word encoder to produce signals merged to intermediate position P6 as required to maintain a desired minimum spacing between ternary 1 and/or ternary 2 code symbols. In other words the outputs of encoder 40 become P5, P6 and P'1 in place of P2, P3 and P'1 respectively. The 1's shift register 42 and 2's shift register 44 interim are each capable of receiving twelve inputs P1 to P6 plus P'1 to P'6 with six positions being read out serially during an interval when four binary data bits are being serially loaded into present data word register 30 and following data word register 22. In the encoding scheme shown in Figure 6, four binary data bits are encoded into six ternary code signal positions. The identification of columns in Figure 6 corresponds to that employed in Figure 2. Inspection of Figure 6 indicates that position P6 is tentatively encoded as a ternary 0 code signal in all cases. When position P5 of a present word and position P'1 of a following word both contain a ternary code signal, either a ternary 1 or 2 code symbol, a merging takes place by deleting the code signals tentatively encoded into positions P5 and P'l and writing into position P6 the symbol tentatively encoded at position P'l. Such merging ensures avoidance of ambiguity because it will be noted that tentative encoding of position P5 is always a ternary 0 or 1 and never a ternary 2. Further inspection of Figure 6 indicates that merging will be required when the following word is a word identified by a serial numbers 8-15, inclusive, and the present word is a word identified by serial numbers 6, 7, 9 or 13. Since position P5 is encoded only as a ternary 0 or ternary 1 code symbol and never as a ternary 2 code symbol, merging alone is sufficient to maintain at least two zeros between ternary 1 and/or ternary 2 code symbols, that is, a skip operation is not required. More specifically,if a serial number 8, 9, 10 or 11 data word follows a serial number 6, 7, 9 or 13 data word the ternary 1 code signal at position P5 of the present data word and the ternary 1 code signal at position P'l of the following data word are merged as a ternary 1 code signal to position P6 corresponding to the present data word. Alternatively, if a serial number 12, 13, 14 or 15 data word follows a serial number 6, 7, 9 or 13 data word the ternary 1 code signal at position P5 of the present data word and the code signal representative of a ternary 2 at position P'l of the following data word are merged as a code signal representative of a ternary 2 code symbol to position P6 corresponding to the present data word. Detection of a ternary 1 code symbol at a P6 position during data recovery operation is construed as a ternary 1 code symbol at the associated P5 and P'l positions. Detection of a ternary 2 code symbol at a P6 position during data recovery operation is interpreted as representative of a ternary 2 at the associated P'l position and as a ternary 1 at the associated P5 position which, as previously mentioned, is correct because only ternary 0 or ternary 1 code symbols are encoded at position P5.

In addition to performing a merging operation for maintaining a prescribed minimum spacing between adjacent ternary 1 and/or ternary 2 code symbols, a substitution procedure somewhat like that explained in the U.S. patent 4,323,931 may be utilised in the present invention to preclude the maximum spacing between adjacent ternary 1 and/or ternary 2 code symbols from exceeding some predetermined amount. Referring to Figure 6, it will be noted that serial number 4, 5, 8 and 12 data words have a ternary 1 or ternary 2 code symbol occurring only in the P1 or P2 positions whereas serial number 0, 1, 2 and 3 data words do not have a ternary 1 or ternary 2 code symbol occurring at the P1 and P2 positions. Thus, for various combinations of such data words, one following the other, anywhere from six to nine ternary zeros may occur intermediate ternary 1 and/or ternary 2 code symbols. By using alternate code signal patterns, as will be explained presently, in such instances the number of ternary zeros between ternary 1 and/or ternary 2 code symbols will be held to a maximum of six thus assuring more frequent synchronisation of the phase locked oscillator on read out and enhancing data recovery. Figure 6 indicates that position P3 has a ternary 1 or ternary 2 code symbol only for the serial number 2 and 3 data words which do not have a ternary 1 or ternary 2 code symbol at the P1 position whereby merging to a P6 position will not occur when a serial number 2 or 3 data words follows a serial number 6, 7, 9 or 13 data word for which a ternary 1 code symbol appears at the P5 position. Hence alternate patterns can be substituted in the following manner for holding the number of ternary zeros to a predetermined maximum between ternary 1 and/or ternary 2 code symbols. In the cases of a serial number 4 or 5 data word followed by a serial number 0, 1, 2 or 3 data word the ternary code symbol at position P2 for the present data word is shifted to position P3 and a ternary 1 code symbol is inserted at position P6 of the present data word thereby ensuring unique coding to facilitate recovery of the various combinations of such data words. In other words the ternary 1 code symbol at position P6 accompanied by a ternary 1 or ternary 2 code symbol at position P3 indicates that symbol at the P6 position is to be omitted on data recovery, that is, not interpreted as the merger of code signals at position P5 of the present word and position P1 of the following word and the symbol at the P3 position is to be construed as the same symbol properly at the P2 position. In those cases of a serial number 8 or 12 data word followed by a serial number 0, 1, 2 or 3 word, the ternary code symbol at position P1 is shifted to position P3 and a ternary 2 code symbol is inserted at position P6 as indicative of the shift from the P1 to the P3 position.

Thus it will be seen that the present invention provides a method for encoding data in ternary form and an apparatus for carrying out such method which increases the capacity of the magnetic medium without requiring any change in the medium and/or the read/write head associated with the medium. This is made possible by appropriately encoding the binary data and by recording the encoded data by saturation recording techniques.

The ternary encoding system described herein is not limited to encoding by the use of a transition to represent a ternary 1 code symbol and use of a pulse to represent a ternary 2 code symbol. Other kinds of signal changes may also be used. For example, a ternary 1 may be represented by a transition of one polarity and a ternary 2 represented by a transition of opposite polarity. Alternatively, pulses of opposite polarity may be used to represent the ternary 1 and ternary 2 symbols. In such systems, control transitions would be inserted, in accordance with well known techniques, as needed to make a transition or pulse change of appropriate polarity. Likewise, the ternary 0 code symbol is not limited to being represented by an absence of signal change but instead may be represented by some kind of signal change intermediate or different from a ternary 1 or ternary 2 code symbol.

Claims

1.    A method of encoding a binary data signal stream, comprising dividing the signal stream into contiguous binary groups (D1, D2) of n bit intervals (59) each, where n is an integer greater than unity, and encoding each binary group (D1, D2) into a corresponding group (P1, P2, P3) of m cells (60), where m is an integer greater than n, characterized in that each binary group (D1, D2) is encoded as a ternary code group (P1, P2, P3) having m cells (60) each of which cells (60) contains a first kind of signal change (62, 64), or a second kind of signal change (61), or other than a signal change of either kind.

2.    A method as claimed in claim 1 employing two level ternary encoding.

3.    A method as claimed in claim 1 or claim 2 in which the cells contain a first kind of signal change to represent ternary 1, a second kind of signal change to represent ternary 2, and no signal change of the first or the second kind to represent ternary 0.

4.    A method as claimed in claim 2 or claim 3 using two distinct signal levels in which the first kind of signal change is a single transition (62, 64) from one signal level to the other, the second kind of signal change is a pair of closely spaced transitions (61) from one signal level to the other and back, and in which any cells not occupied by either a signal change of the first kind or the second kind do not contain any signal change.

5.    A method of recording binary data on a magnetic recording medium employing a method of encoding as claimed in any preceding claim.

6.    A method of recording as claimed in claim 5 in which two distinct signal levels are provided by saturation magnetisations of opposite orientation.

7. A method of recording as claimed in claim 5 or claim 6, in which the spacing of two transitions of a pair (61) of transitions is such that when detected by a read head (52) the two transitions so interact with each other as to reduce the amplitude (65) of the resulting read signal compared to the amplitude (67, 68) of the read signal resulting from detention of a single transition.

8. A method as claimed in any one of the preceding claims in which two adjacent signal changes occupying cells less than a predetermined minimum number of cells apart are replaced by a single signal change in one of the occupied or one of the intermediate cells.

9. A method as claimed in any one of the preceding claims, in which one or more additional signal changes are inserted in cells intermediate two adjacent signal changes more than a predetermined maximum number of cells apart.

10. A method as claimed in claim 9 in which insertion of signal changes is accompanied by shifting of selected signal changes.

11. A method as claimed in any one of claims 8 to 10 in which each binary group (D1, D2) is encoded together with the next following binary group (D'1, D'2).

12. A method as claimed in claim 11 in which signal changes less than the minimum number of cells apart are replaced by a like signal change in one of the intermediate cells if both signal changes are of the same kind, and are replaced by one of the extant signal changes being retained in its cell and the other being omitted, if the signal changes are not of the same kind.

13. A method as claimed in claim 12 in which the signal change is omitted from the present codeword (P1, P2, P3), and the signal changes are replaced by a signal change in the next following codeword (P'1, P'2, P'3).

14. A method as claimed in any preceding claim in which each binary group has n = 2 bit intervals (D1, D2) and each ternary code group has m = 3 cells (P1, P2, P3).

15. A method as claimed in any one of claims 1 to 13 in which each binary group has n = 4 bit intervals (D1, D2, D3, D4) and each ternary code group has m = 5 cells (P1, P2, P3, P4, P5).

16. Apparatus to encode a binary data signal stream according to the method as claimed in any one of claims 1 to 15.

13. Apparatus as claimed in claim 16 comprising data storage means (30, 24) to divide the signal stream into a present and a following binary group (D1, D2 and D'1, D'2) of n bit intervals (59) each, encoding means (36, 38) for the present and for the next following binary group, each having n inputs coupled to the data storage means (30, 22) and having m output channels (P1, P2, P3 and P'1, P'2, P'3) to establish a parallel code signal pattern selective of a ternary code group, the output channels being coupled to serializing means (42, 44), a corresponding serial stream of code signals supplied at cell frequency to signal change generating means (46).

18. Apparatus as claimed in claim 18 in which the encoding means further includes merge and skip encoding means (40) which are interposed between at least some of the output channels (P1, P2, P3 and P'1, P'2 P'3) and the serializing means (42, 44), and which are arranged to replace code signals selective of signal changes less than a predetermined number of cells apart by code signals causing them to be replaced.

19. Apparatus as claimed in claim 17 or claim 18 in which the data storage means divide the signal stream into bit groups of two bit intervals each, and in which the encoding means (36, 38) for the present and the following bit group each have three output channels (P1, P2, P3 and P'1, P'2, P'3).

20. A magnetic data recording system including apparatus as claimed in any one of claims 12 to 15.

| BINARY WORD | | THEORETICAL CODE WORD | | |
|---|---|---|---|---|
| D1 | D2 | P1 | P2 | P3 |
| 0 | 0 | 0 | 1 | 0 |
| 0 | 1 | 0 | 2 | 0 |
| 1 | 0 | 1 | 0 | 0 |
| 1 | 1 | 2 | 0 | 0 |

Fig-1

| SERIAL NUMBER | DATA WORDS | | | | TERNARY CODE WORDS | | | | | |
|---|---|---|---|---|---|---|---|---|---|---|
| | PRESENT | | FOLLOWING | | PRESENT | | | FOLLOWING | | |
| | D1 | D2 | D'1 | D'2 | P1 | P2 | P3 | P'1 | P'2 | P'3 |
| 0 | 0 | 0 | 0 | 0 | 0 | 1 | 0 | 0 | 1 | 0 |
| 1 | 0 | 0 | 0 | 1 | 0 | 1 | 0 | 0 | 2 | 0 |
| 2T | 0 | 0 | 1 | 0 | 0 | 1 | 0 | 1 | 0 | 0 |
| 2 | 0 | 0 | 1 | 0 | 0 | 0 | 1 | 0 | 0 | 0 |
| 3T | 0 | 0 | 1 | 1 | 0 | 1 | 0 | 2 | 0 | 0 |
| 3 | 0 | 0 | 1 | 1 | 0 | 0 | 0 | 2 | 0 | 0 |
| 4 | 0 | 1 | 0 | 0 | 0 | 2 | 0 | 0 | 1 | 0 |
| 5 | 0 | 1 | 0 | 1 | 0 | 2 | 0 | 0 | 2 | 0 |
| 6T | 0 | 1 | 1 | 0 | 0 | 2 | 0 | 1 | 0 | 0 |
| 6 | 0 | 1 | 1 | 0 | 0 | 0 | 0 | 1 | 0 | 0 |
| 7T | 0 | 1 | 1 | 1 | 0 | 2 | 0 | 2 | 0 | 0 |
| 7 | 0 | 1 | 1 | 1 | 0 | 0 | 2 | 0 | 0 | 0 |
| 8 | 1 | 0 | 0 | 0 | 1 | 0 | 0 | 0 | 1 | 0 |
| 9 | 1 | 0 | 0 | 1 | 1 | 0 | 0 | 0 | 2 | 0 |
| 10 | 1 | 0 | 1 | 0 | 1 | 0 | 0 | 1 | 0 | 0 |
| 11 | 1 | 0 | 1 | 1 | 1 | 0 | 0 | 2 | 0 | 0 |
| 12 | 1 | 1 | 0 | 0 | 2 | 0 | 0 | 0 | 1 | 0 |
| 13 | 1 | 1 | 0 | 1 | 2 | 0 | 0 | 0 | 2 | 0 |
| 14 | 1 | 1 | 1 | 0 | 2 | 0 | 0 | 1 | 0 | 0 |
| 15 | 1 | 1 | 1 | 1 | 2 | 0 | 0 | 2 | 0 | 0 |

T MEANS TENTATIVE, BEFORE MERGE/SKIP

Fig-2

Fig_3

0064406

3/4

*Fig_4*

*Fig_5*

| SERIAL NUMBER | DATA WORD | | | | TERNARY CODE WORD | | | | | |
|---|---|---|---|---|---|---|---|---|---|---|
| | D1 | D2 | D3 | D4 | P1 | P2 | P3 | P4 | P5 | P6 |
| 0 | 0 | 0 | 0 | 0 | 0 | 0 | 0 | 1 | 0 | 0 |
| 1 | 0 | 0 | 0 | 1 | 0 | 0 | 0 | 2 | 0 | 0 |
| 2 | 0 | 0 | 1 | 0 | 0 | 0 | 1 | 0 | 0 | 0 |
| 3 | 0 | 0 | 1 | 1 | 0 | 0 | 2 | 0 | 0 | 0 |
| 4 | 0 | 1 | 0 | 0 | 0 | 1 | 0 | 0 | 0 | 0 |
| 5 | 0 | 1 | 0 | 1 | 0 | 2 | 0 | 0 | 0 | 0 |
| 6 | 0 | 1 | 1 | 0 | 0 | 1 | 0 | 0 | 1 | 0 |
| 7 | 0 | 1 | 1 | 1 | 0 | 2 | 0 | 0 | 1 | 0 |
| 8 | 1 | 0 | 0 | 0 | 1 | 0 | 0 | 0 | 0 | 0 |
| 9 | 1 | 0 | 0 | 1 | 1 | 0 | 0 | 0 | 1 | 0 |
| 10 | 1 | 0 | 1 | 0 | 1 | 0 | 0 | 1 | 0 | 0 |
| 11 | 1 | 0 | 1 | 1 | 1 | 0 | 0 | 2 | 0 | 0 |
| 12 | 1 | 1 | 0 | 0 | 2 | 0 | 0 | 0 | 0 | 0 |
| 13 | 1 | 1 | 0 | 1 | 2 | 0 | 0 | 0 | 1 | 0 |
| 14 | 1 | 1 | 1 | 0 | 2 | 0 | 0 | 1 | 0 | 0 |
| 15 | 1 | 1 | 1 | 1 | 2 | 0 | 0 | 2 | 0 | 0 |

Fig_6

# European Patent Office

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US-A-3 713 123 (LIPP)<br><br>*Figures 1-6; from column 5, line 27 to column 18, line 63* & GB - A - 1 301 918 & FR - A - 2 073 999 & DE - A - 2 061 712<br><br>--- | 1-6,8-10 | G 11 B 5/09<br>H 04 L 25/49 |
| X | US-A-3 609 684 (LIPP)<br><br>*Figures 1-8; from column 4, line 7 to column 17, line 8* & GB - A - 1 343 153 & DE - A - 2 120 717<br><br>--- | 1-6,8-10 | |
| A | IBM TECHNICAL DISCLOSURE BULLETIN, vol. 15, no. 11, April 1973, pages 3413-3414, New York (USA);<br>D.W.CHAPMAN et al.: "Phase modulated NRZI code".<br><br>--- | 1-6 | |
| A | IBM TECHNICAL DISCLOSURE BULLETIN, vol. 15, no. 10, March 1973, page 3098, New York (USA);<br>D.W.CHAPMAN: "Phase modulated code".<br><br>--- | 1 | **TECHNICAL FIELDS SEARCHED (Int. Cl. ³)**<br><br>G 11 B<br>H 04 L |
| A | US-A-3 870 870 (GABOR)<br><br>--- | 1,13-14,17 | |

/

The present search report has been drawn up for all claims

| Place of search | Date of completion of the search | Examiner |
|---|---|---|
| THE HAGUE | 05-07-1982 | CARTRYSSE A.A.H. |

## European Patent Office

# DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | FR-A-2 067 311 (GENERAL DYNAMICS CORPORATION) *Figures 1,3,10; from page 10, line 9 to page 12, line 6 and page 25, lines 37-40* & US - A - 3 618 044 & GB - A - 1 332 329 | 1 | |
| A | US-A-3 226 685 (POTTER et al.) & FR - A - 1 334 364 | 1 | |
| A | US-A-3 274 611 (BROWN et al.) | 1 | |
| A | DE-B-2 020 089 (ALBISWERK ZURICH) | 1 | |
| A | ELECTRICAL COMMUNICATION, vol. 48, no. 1,2, 1973, pages 79-92, New York (USA); A.JESSOP et al.: "120-Megabit per second coaxial system demonstrated in the laboratory". | 1 | TECHNICAL FIELDS SEARCHED (Int. Cl. ³) |

-----

The present search report has been drawn up for all claims

| Place of search | Date of completion of the search | Examiner |
|---|---|---|
| THE HAGUE | 05-07-1982 | CARTRYSSE A.A.H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82